(19) Europäisches Patentamt
European Patent Office
Office européen des brevets

(11) Publication number: **0 132 398**
**B1**

(12) # EUROPEAN PATENT SPECIFICATION

(45) Date of publication of patent specification: **04.10.89**

(51) Int. Cl.$^4$: **H 01 J 27/02**, C 23 C 14/48, G 11 B 5/84

(21) Application number: **84304963.6**

(22) Date of filing: **20.07.84**

(54) **A method and apparatus for ion beam generation.**

(30) Priority: **20.07.83 JP 133030/83**
**20.07.83 JP 133031/83**
**20.07.83 JP 133032/83**
**20.07.83 JP 133033/83**

(43) Date of publication of application:
**30.01.85 Bulletin 85/05**

(45) Publication of the grant of the patent:
**04.10.89 Bulletin 89/40**

(84) Designated Contracting States:
**DE FR GB**

(56) References cited:
**EP-A-0 019 725**
**EP-A-0 021 140**
**EP-A-0 094 473**
**EP-A-0 106 497**
**GB-A-2 106 939**
**US-A-4 351 712**

(73) Proprietor: **KONISHIROKU PHOTO INDUSTRY CO. LTD.**
**No. 26-2, Nishishinjuku 1-chome Shinjuku-ku**
**Tokyo 160 (JP)**

(72) Inventor: **Naoe, Masahiko**
**1-36-10 Kitasenzoku**
**Ohta-ku Tokyo (JP)**
Inventor: **Ishibashi, Shouzo**
**Konishiroku Photo Industry Co. Ltd. 1 Sakura-machi**
**Hino-shi Tokyo (JP)**

(74) Representative: **Ellis-Jones, Patrick George Armine et al**
**J.A. KEMP & CO. 14 South Square Gray's Inn**
**London WC1R 5EU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to a method and apparatus for ion beam generation.

Magnetic recording media, such as magnetic tapes and discs, have been widely used for recording various electrical signals, for example, from video, audio, and digital systems. New magnetic materials and coating techniques have been tested and applied in an effort to achieve higher recording densities in recording systems that use in-plane longitudinal magnetization of a magnetic recording layer formed on a substrate for signal recording. As an alternative approach to achieve higher recording densities in a magnetic recording medium, use of magnetization in the direction of the thickness or so-called "vertical magnetization" of the magnetic layer of a magnetic recording medium has been proposed, for example, in the journal "Nikkei Electronics", No 192 issued on Aug. 7, 1978. This recording system has a demagnetizing field that works on the residual magnetization in the medium which decreases as the recording wavelength gets shorter. This recording system is suited to high density recording by nature and is presently studied for practical applications.

In the above in-plane longitudinal recording system and vertical recording system, it is possible to use iron nitride ($Fe_{1-x}N_x$) as a material for the recording/reproducing head. To form the $Fe_{1-x}N_x$ film, it is known to sputter an iron target in an atmosphere of argon and nitrogen or to evaporate iron in an atmosphere of nitrogen. However, these methods have not yet been fully investigated regarding how various relevant parameters are interrelated to one another in defining the condition of the deposition of the magnetic layer of $Fe_{1-x}N_x$. It is therefore not possible to consistently form a magnetic layer having favorable characteristics by these methods.

The present invention seeks to provide a method of consistently preparing a thin film having favorable characteristics, for the magnetic layer as mentioned above, using the sputtering method. The invention also seeks to prepare a magnetic head which exhibits high magnetization, low coercive force and high anticorrosive properties.

This invention provides a method of ion beam generation wherein plasma is generated in a space between opposed targets, at least one target being composed of iron, and nitrogen gas is fed into the space to sputter said targets, the ionized particles of iron nitride thereby generated being led outside said space in a given direction under energy control of said ionized particles in an electric field.

The invention also provides an ion beam generator comprising a plurality of opposed targets, at least one target being composed of iron, a plasma generating means to generate plasma necessary for sputtering said targets in a space between said targets, gas feeding means to feed said space with nitrogen containing gas, at least one control electrode to lead ionized particles thus produced outside of the space, and means to control the energy of the ionized particles.

Fig. 1 is a sectional view of an ion beam generator embodying the invention.

Fig. 2 is a diagram illustrating the principle of how opposing targets are sputtered.

Fig. 3 is a plan view of the target across which an ion beam is led out and a control grid next thereto.

Fig. 4 is a sectional view taken along the line X—X of Fig. 3.

Fig. 5 is a diagram illustrating an electrical circuit configuration of the above apparatus.

Fig. 6 is a potential distribution diagram over individual parts of the apparatus.

Fig. 7 is a sectional view of a magnetic recording medium embodying the invention.

Fig. 8 is a sectional view of a vertical magnetic recording system.

Fig. 9 is a schematic representation of a magnetic head.

Fig. 10 is a diagram showing how the crystalline structure of a deposited film is determined by the partial pressure of nitrogen gas and the temperature of substrate.

Fig. 11 is an X-ray diffraction diagram of a deposited film.

Fig. 12 is a diagram showing how the saturated magnetization and coercive force of the deposited film depend of the partial pressure of nitrogen gas.

Fig. 13 is a diagram showing how the saturated magnetization of deposited film depends on the temperature of substrate.

Fig. 14 is a diagram showing how the saturated magnetization of deposited film depends on the accelerating voltage.

Fig. 15 shows a hysteresis loop of the deposited film.

Figs. 1 to 6 illustrate an embodiment of an ion beam generator in accordance with the invention which can be used in the formation of a thin film, made of $Fe_{1-x}N_x$, and its operating principle.

The apparatus shown in Fig. 1 is essentially composed of two sections, an opposing target sputtering section A and an ion beam outlet section B that emits ionized particles from sputtering section A.

In the sputtering section A, a vacuum chamber 1 is equipped with a gas introducing tube 2, which is used to introduce a gas of given composition, for example $Ar+N_2$, into vacuum chamber 1 to provide a gas pressure, preferably of $133.10^{-3}$ to $10^{-4}$ Pa ($10^{-3}$ to $10^{-4}$ Tors). The exhaust system of the chamber 1 is omitted from the figure. A pair of target electrodes T1 and T2 made of iron are held by target holders 4 in such a position that they are parallel with a gap inbetween. In the space between these targets, there is a magnetic field generated by an external magnetic field generating means 3 which may be a magnet coil. Beside the above, a cooling water inlet pipe 5, cooling water outlet pipe 6, and accelarating electrode 13 appear in the figure.

In the sputtering section A as constructed above, a magnetic field is formed perpendicular to the surfaces of opposing targets T1 and T2. As sputtering gas ions are accelerated in electric fields in the cathode drop regions (regions 8 and 9 in Fig. 2, which are regions between each target T1 and T2, respectively, and a plasma atmosphere 7 that is formed between both targets T1 and T2) and collide against the surfaces of these targets, the target material is sputtered by the impact and electrons are released from the surfaces. These electrons are driven towards the opposite target and are repelled by the cathode drop region in front of the target and are thus confined in the space between the targets by the magnetic field present. The electrons thus repeat reciprocating motions between the targets T1 and T2 under confinement by the magnetic field.

During these reciprocating motions, the electrons collide against netural molecules and atoms of the gaseous atmosphere and cause their ionization. The products of this ionization, ions and electrons, in turn further facilitate release of electrons from the targets and cause further ionization of the atmospheric gas. As a result, plasma of a high density is formed between the targets T1 and T2 causing satisfactory sputtering of the target material.

Thus, in contrast to other material depositing means, this sputtering system forms a film at higher rates of sputtering and deposition, and the substrate, which is not directly exposed to plasma, can therefore be kept at a lower temperature during film formation.

A further structural feature of the system of Fig. 1 is the provision of an ion beam outlet section B. As iron that is first sputtered from targets in the sputtering section A reacts with the $N_2$ gas and is then ionized, the resultant ionized particles of $Fe_{1-x}N_x$ are emitted in this outlet section B. This section B has a screen grid G close to the outer surface of the target T2. Both the grid G and target T2 are maintained at their given potentials and have small through-holes 11 and 12, respectively, in corresponding patterns as illustrated in Figs. 3 and 4. For example, the small through-holes 11 and 12 may be sized 2 mmφ and pitched 5 mm while the grid G may be 1 mm thick.

Fig. 5 illustrates an electrical circuit configuration to operate the above system. With the accelerating electrode 13 set at an accelerating voltage of Vp, a negative voltage Vt is applied to both targets T1 and T2 while the grid G is grounded, with a substrate S disposed in the ion beam outlet section B. Fig. 6 shows the potential distribution among individual portions of the circuit system. Preferably Vp and Vt are 0 to 200 V and 500 to 1000 V, respectively.

If the above system is operated in the condition as mentioned above, ions in the plasma generated in the sputtering section A, preferably set to a pressure of $10^{-3}$ to $10^{-4}$ Torr (0.133 to 0.013 Pa), are accelerated in the cathode drop region 9 (see Fig. 2) by the acceleration electrode 13 in the direction of the target T2. They then pass the small through-holes 11 and 12 and are decelerated in an electric field provided between the target T2 and grid G. They are thus emitted through holes 11 and 12 with an energy corresponding to the potential difference between the plasma and substrate S. The ion beam 10 thus emitted is focussed in an electric field E formed in the outlet section B, preferably set to a pressure of $10^{-5}$ Torr ($1.333\times10^{-3}$ Pa) or less (see Fig. 1). The beam 10 thus impinges on the surface of the substrate S with the energy as mentioned above. Thus, by controlling the energy of the ionized particles of $Fe_{1-x}N_x$ depositing on the surface of substrate S by adjusting the anode voltage Vp that is applied to the anode or accelerating electrode 13, the ion beam 10 can be emitted from sputtering section A and directed to the substrate S in an electric field provided by the grid G. Since the chamber where the substrate S is placed is evacuated to a high vacuum, preferably of $10^{-5}$ Torr ($1.333\times10^{-5}$ Pa) or less, a clean magnetic layer with few impurities can thus be deposited.

Preferably, the through-holes 11 and 12 in the target T2 and grid G are not made excessively wide, since this allows a leak of gas from the sputtering section A to the ion beam outlet section B where the substrate S is placed because of a difference in the gas pressure between these sections. This often results in a higher impurity level in the deposited film. Too large through-holes also reduce the mechanical strength of the target T2 and grid G and may lower the sputtering efficiency because of a reduction in the effective target area.

Using the method and system as explained above, a magnetic recording medium, for example, as illustrated in Fig. 7, such as the magnetic tape or magnetic disc, may be formed, having a magnetic layer 14 of $Fe_{1-x}N_x$ 2000 Å (200 nm) thick on a substrate S. The magnetic layer 14 formed in this magnetic recording medium is suitable either for in-plane longitudinal magnetic recording or vertical magetic recording. This layer 14 can be composed of amorphous iron nitride $Fe_{1-x}N_x$. In this case, it is in an amorphous state with no phase separation in its structure, in other words, it is a single phase with no grain boundaries. It thus satisfies the requirements of the magnetic material of magnetic recording medium. The parameter x in the above formula $Fe_{1-x}N_x$ preferably is greater than or equal to 0.4, for, if x is less than 0.4, the nitrogen content is not high enough to provide an amorphous state. The magnetic recording medium of Fig. 7 may comprise a substrate S, for example of aluminium or polyethylene terephthalate, with a magnetic recording layer 14 formed thereon whose principal component is amorphous $Fe_{1-x}N_x$. This principal component may account for 100% of the layer or, beside the principal component, the layer may also contain a secondary component or components. Examples of suitable secondary components are metals, such as Ni, Al, Ti, V, Cr, Mn, Cu, W, Pt, Zr, Nb and Mo, semiconductors, such as Si and Ge, and non-metals, such as C, F, Ne, P, S, As and Se. The compound $Fe_{1-x}N_x$ preferably has a composition from $Fe_{60}N_{40}$ (x=0.4) to $Fe_{50}N_{50}$ (x=0.5). Being amorphous iron nitride with no phase separation, this compound $Fe_{1-x}N_x$ exhibits a coercive force Hc=400 to 600 Oersted (31831 to 47746 A/m) high enough for magnetic recording and also a high saturated magnetization, for example, 12 kgauss (1.2 T). Furthermore, having nitrogen as a component, the compound $Fe_{1-x}N_x$ is substantially resistant to corrosion.

As shown by the solid line and interrupted line in the magnetic recording medium of Fig. 7, both the front and back surfaces of the substrate S may be provided with a magnetic layer 14, based on the above amorphous iron nitride $Fe_{1-x}N_x$, for use as a magnetic disc.

Further, as shown in Fig. 8, the $Fe_{1-x}N_x$ based magnetic layer 14 as mentioned above may be deposited, for example, as a 2000 Å (200 nm) thick layer on a glass substrate S as the main magnet 17 that is disposed opposite to the auxiliary magnet 16 as a set-up of recording head to be used in vertical magnetic recording in the magnetic recording medium 15. More particularly, for the magnetic layer 14 of this main magnet 17, γ'-$Fe_4N$ or α-Fe and γ'-$Fe_4N$ may be deposited on a glass substrate S and covered by a protective layer cover 18 which is, for example, a glass plate. The magnetic material $Fe_{1-x}N_x$ on which the magnetic layer 14 is based provides a saturated magnetization large enough for signal recording while exhibiting a low coercive force Hc that is required for the magnetic recording head. Therefore, the head with such magnetic layer 14 formed for the permeable layer has good performance. Moreover, the high anticorrosive property of the nitrogen-containing compound $Fe_{1-x}N_x$ also contributes to improved performance of the head.

In the vectical magnetic recording system attained with this magnetic recording head, the auxiliary magnet 16, as it is energized by the incoming signal to be recorded, generates a magnetic field extending beyond a recording medium 15 concentrating a magnetic flux toward the main magnet 17 in the in-plane direction thereof. Thus, a magnetic recording is made in the magnetic layer of the medium 15 corresponding to the current magnetization of the main magnet 17.

Fig. 9 illustrates another magnetic head 27. This head comprises a magnetic layer 14, based on $Fe_{1-x}N_x$, formed on both of the end faces of the core S, for example made of ferrite, which are opposed to each other across the magnetic gap 20 of the core. It is noted that even whole surfaces of the head may be covered with $Fe_{1-x}N_x$ for this purpose. The magnetic heads as mentioned above to which the $Fe_{1-x}N_x$ magnetic material is applied are particularly suitable to high density recording.

The $Fe_{1-x}N_x$ magnetic layer may be formed to provide magnetic heads other than the above, for example, a thin film head.

The $Fe_{1-x}N_x$ magnetic layer is further described using the following experimental results.

(A) Structure of the $Fe_{1-x}N_x$ layer

The layer formed was found to be crystalline, though its crystalline structure depended on the percentage of nitrogen gas present, the temperature of substrate Ts and the ion accelerating voltage Vp.

Fig. 10 shows how the crystalline structure of the magnetic layer deposited on a (111) plane of silicon substrate under the total pressure $P_{total}$ of $5\times10^{-4}$ Torr (0.067 Pa) and Vp=20 V depended on the partial pressure of nitrogen gas $^{P}N_2$ and Ts. For example, at Ts=200°C the deposited layer exhibited a higher degree of nitration with increasing partial pressure $^{P}N_2$, the crystalline phase thereof changing in the following sequence as this parameter is increased; mixed phase of α-Fe and γ'-$Fe_4N$, single phase of γ'-$Fe_4N$, mixed phase of ζ-$Fe_3N$ and ζ-$Fe_2N$, and then single phase of ζ-$Fe_2N$. It is noted that in the mixed phase of α-Fe and γ'-$Fe_4N$, there was found an unknown crystalline phase (U/K) having a spacing of 1.9 to 2.0 A (0.19 to 0.20 nm). As Ts increases above 200°C, boundaries between individual regions shift for higher values of $^{P}N_2$. Also below 200°C, there is less nitration as Ts is lowered. For example, only a single phase of α-Fe is formed at Ts=80°C and $^{P}N_2=4\times10^{-5}$ Torr (0.067 Pa).

Fig. 11 is an example of the X-ray diffraction patterns observed with an $Fe_{1-x}N_x$ magnetic layer as fabricated in various conditions. Among the phase that were formed in these layers, the ε-$Fe_3N$ and ζ-$Fe_2N$ phases presented random orientation of their crystals while the <110> direction of the α-Fe phase of body centered cubic structure and the <100> direction of the γ'-$Fe_4N$ phase of face centered cubic structure showed orientation vertical to the layer. The α-Fe phase and γ'-$Fe_4N$ phase as formed by the conventional sputtering method that makes use of neutral particles alone for deposition exhibit a tendency of orienting their closest packed planes, namely, (110) and (111) planes, respectively, with a decreasing pressure of the gaseous atmosphere. The above results thus suggest that with the ion beam deposition of the present invention a high kinetic energy and uniform orientation of depositing particles might facilitate oriented deposition of the film and that when depositing particles were charged the orientation might occur with respect to a different lattice plane other than the closest packed one depending on the type of compound.

It was further investigated how the X-ray diffraction pattern as observed with the layer deposited under a fixed condition of $P_{total}=5\times10^{-4}$ Torr (0.067 Pa), $^{P}N_2=1.5\times10^{-5}$ Torr (0.002 Pa) and Ts=150°C changed with Vp. Vp=0 V gave a diffraction spectrum corresponding to

the $\alpha$-Fe phase with the (110) plane orientated. By contrast, at Vp=40 V, broad peaks were clearly detected at diffraction angles corresponding to the (111) and (200) planes of $\gamma'$-$Fe_4N$ phase. At Vp=60 V, however, the diffraction pattern reduced again to the spectrum corresponding to the (110) plane of $\alpha$-Fe phase alone. These results showed that in the range of Vp=0 to 40 V the proportion of the $\gamma'$-$Fe_4N$ phase increased with an increasing Vp. While the $\gamma'$-$Fe_4N$ phase of the layer deposited at Vp=40 V and Ts=150°C was randomly oriented, the same phase in the layer previously mentioned that was deposited at Vp=20 V and Ts=200°C showed orientation of the (200) plane. Since a higher Vp gives a larger kinetic energy to the depositing ions and thereby increases the temperature at the surface of substrate and the mobility of deposited particles there, it is likely that the reaction between the iron and nitrogen may be facilitated by increasing Vp. The results at Vp=60 V suggest a possibility that excessive kinetic energies of the depositing ions might suppress formation of bonds between the iron and nitrogen or these bonds might be formed but then broken as they are hit by other particles. Further, it can be asserted that the orientation in the layer is lowered as high energy particles that are generated under acceleration at a higher Vp hit the substrate.

(B) Saturated magnetization of the $Fe_{1-x}N_x$ layer

The saturated magnetization 4πMs of the layer was determined on a magnetic balance. Figures 12 and 13 illustrate how this parameter depended on the condition of deposition. These figures show how 4πMs of the layer deposited at $P_{total}=5\times10^{-5}$ Torr ($6.67\times10^{-3}$ Pa) and Vp=20 V depend on $^PN_2$ and Ts. In both regions where the deposited layer presented in a mixed phase of $\alpha$-Fe+$\gamma'$-$Fe_4N$+U/K and a single phase of $\gamma'$-$Fe_4N$, respectively, the saturated magnetization was higher than that of the pure iron (21.6 kgauss) (2.16 T). Particularly, around the boundary between these two regions, it showed a peak of about 25 kgauss (2.5 T). Such high saturated magnetization could be attributed to the presence of the $\gamma'$-$Fe_4N$ and unknown phases. In the diagram of Figure 10, the hatched area represents the region of such high saturated magnetization. A film of $Fe_{1-x}N_x$ in this region has a high saturated magnetization and low coercive force Hc, so it performs well as a head material. The $\gamma'$-$Fe_4N$ phase exhibits a saturated magnetization of approx. 24 kgauss (2.4 T), which almost corresponds to the values of 22 to 24 kgauss (2.2 to 2.4 T) as determined with the single phase of $\gamma'$-$Fe_4N$ available in the present invention. The peak saturated magnetization as high as 25 kgauss (2.5 T) thus indicates that the unknown phase has a higher saturated magnetization than the $\gamma'$-$Fe_4N$ phase. The fact that in the above diagram the deposited layer attains the high saturated magnetization near the boundary between the region of mixed phase of

$$\alpha\text{-Fe}+\gamma'\text{-}Fe_4N+U/K$$

and one of single phase of $\gamma'$-$Fe_4N$ suggests a possible hypothesis that such unknown phase is composed of $Fe_8N$. At

$$P_{total}=5\times10^{-4} \text{ Torr (0.067 Pa)},$$

Vp=20 V, and Ts=250°C, a magnetic layer of high saturated magnetization could be fabricated in a range of $^PN_2=1.1\times10^{-5}$ to $4.0\times10^{-5}$ Torr ($1.467\times10^{-3}$ to $5.33\times10^{-3}$ Pa) (the nitrogen gas mixing ratio $^PN_2/P_{total}$=2.0 to 8.0%), while at the same levels of $P_{total}$ and Vp and at $^PN_2=3\times10^{-5}$ Torr (0.004 Pa), a range of Ts=150 to 250°C also gave a magnetic layer of high saturated magnetization. The present system thus gives a magnetic layer of high saturated magnetization at a substantially wider range of nitrogen gas mixing ratio as compared to the normal range of $^PN_2/P_{total}$, this being from 2.7 to 4.0% for ordinary radio-frequency sputtering systems. The unknown phase. that is suspected to comprise $Fe_8N$, is liable to be damaged by bombardment with high energy particles and by elevation of the temperature of substrate. It is therefore noted that in case of ordinary radio-frequency sputtering, as the plasma potential and/or sputtering efficiency change with the mixing ratio of nitrogen gas, there may occur changes in the effect of bombardment with high energy particles and in the temperature of substrate in such a direction that the crystalline growth is disturbed, for example, due to destruction of the quasi-stable state. This narrows the region in which the crystalline growth of high saturated magnetization occurs satisfactorily. By contrast, in the ion beam deposition of the invention, the magnetic layer of high saturated magnetization can be deposited in a wider region, for the mixing ratio of the nitrogen gas can be changed more easily.

If $P_{total}$ is increased, the range in which the magnetic layer of high saturated magnetization can be deposited shifts on hotter side. The reason could be that the percentage of depositing particles that was accounted for by ions decreased with an increasing total pressure $P_{total}$, thus lowering the crystallinity of the magnetic layer formed.

As shown in Figure 12, the coercive force Hc increases with increasing partial nitrogen pressure to a level of 400 to 600 Oersted (31831 to 47746 A/m), for example, 500 Oersted (39789 A/m) that is high enough for magnetic recording. As the partial nitrogen pressure is increased, the saturated magnetization 4πMs dips once and then increases again up to a desirable level of above 12 kgauss (1.2 T) or over. It can be reasoned that as the partial nitrogen pressure $^PN_2$ (and the total pressure $P_{total}$) increases the percentage of depositing particles that is accounted for by ions increases, thus lowering the crystallinity of the deposited film down to the stage of amorphous phase.

Figure 14 shows how the saturated magnetization depended on the acceleration voltage Vp. Test samples were prepared either at $P_{total}=5\times10^{-4}$ (0.067 Pa) Torr and Ts=150°C or at $P_{total}=1\times10^{-3}$ (0.133 Pa) Torr and Ts=150°C. It was found that the saturated magnetization 4πMs decreases with increasing Vp. This suggests that the short-distance order in the iron-nitrogen film sharply declined as the energy of depositing particles exceeded the level of 30 eV which corresponded to Vp=20 V.

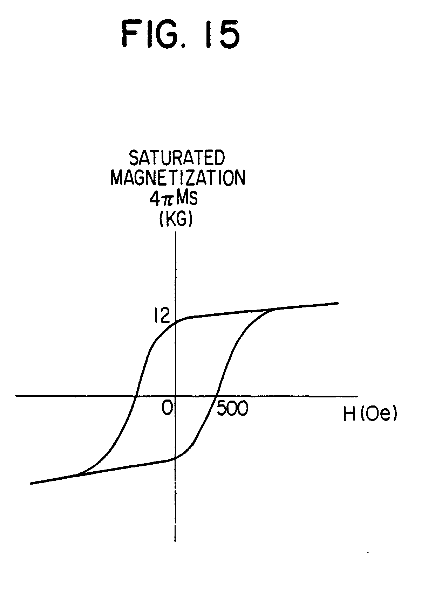

Figure 15 is a hysteresis curve of a deposited film comprising $Fe_{1-x}N_x$ with x=0.4 to 0.5 corresponding to the amorphous state. In this case, Hc=400 to 600 Oersted (31831 to 47746 A/m), for example, 500 Oersted (39789 A/m) was measured on a vibration type magnetometer of known art, thus the coercive force being in a suitable range as the magnetic recording medium.

The above results can be summarized as follows:

(a) The crystalline structure of the deposited iron-nitrogen film changes depending on the partial nitrogen pressure and the temperature of substrate. This finding leads to film formation with good reproducibility.

(b) Among phases available on deposition at the ion acceleration voltage Vp=20 V, α-Fe and γ'-$Fe_4N$ phases show a strong orientation of the (110) and (200) planes, respectively, parallel to the film. This orientation can be accounted for by the high kinetic energy, uniform orientation of the depositing particles, and their charge.

(c) The film exhibits a saturated magnetization of about 25 kgauss (2.5 T), which is higher than that of the pure iron, in a region of depositing conditions where the crystalline structure undergoes a transition from the mixed phase of

$$\alpha\text{-Fe}+\gamma'\text{-}Fe_4N+U/K$$

to the single phase of γ'-$Fe_4N$.

(d) The temperature range in which the film of high saturated magnetization 4πMs can be formed shifts on the less hot side as the total pressure $P_{total}$ declines. It is in the range of from 150 to 250°C at

$$P_{total}\leqq5\times10^{-5}\text{ Torr }(0.67\times10^{-3}\text{ Pa}).$$

This finding suggests that even at a low temperature of substrate the order in the film deposited thereon can be improved by increasing the percentage of depositing particles accounted for by ions.

Paragraph (a) indicates the good controllability of the ion beam deposition method embodying the invention while paragraph (d) reveals the effect of the ionization of depositing particles achieved by the same method. They show that a film of high quality which is hard to produce using the techniques of prior art can be formed by the present ion beam deposition method.

It will be evident that various modifications can be made to the described embodiments. For example, in Figure 1, a plurality of grids may be used instead of the single grid G for control of the ion beam and various substances can be used as one of the targets $T_1$ and $T_2$ instead of Fe. Instead of openings small through-holes 11 in the lower target T2, the screen grid or grids as mentioned above can be disposed on one side of the targets T1 and T2 in a direction perpendicular thereto to lead out an ion beam sideways. In the example of the Figure 1, the $Fe_{1-x}N_x$ film was deposited directly on the surface of substrate S. Instead of the substrate S, however, a third target T3 can be disposed as represented by the dot-interrupted line to bombard it with the ion beam 10 so other ionized particles may be sputtered. These particles are then directed to a substrate S' together with the particles of the above $Fe_{1-x}N_x$ to form a film of a mixed composition between the two. For example, if the permalloy $Ni_{80}Fe_{20}$ is used for the target T3, a magnetic layer composed of a mixture of $Fe_{1-x}N_x$ and permalloy can be formed on the substrate S'. If niobium is used for the target T3, a magnetic layer composed of $Fe_{1-x-y}Nb_yN_x$ is produced on the substrate S'.

In the present invention, as mentioned above, ionized particles that are generated in the sputtering section A with the opposing targets system are emitted in an electric field or under energy control. Therefore, while generating plasma at a high density to improve the sputtering efficiency, the output ion beam can be accurately controlled by adjusting the pressure of introduced gas and control voltages, including the acceleration voltage, to always attain the desired characteristics of the deposited film with good reproducibility.

Iron nitride, if used at least partially for the permeable layer as mentioned above, will give the layer a high magnetization, a low coercive force and high anticorrosiveness characteristic of such material, making it possible to provide a head of high performance. Further, the formation of a magnetic layer based on amorphous iron nitride will provide a magnetic recording medium of high performance which has the high coercive force, magnetization and anticorrosiveness characteristics of the amorphous iron nitride.

**Claims**

1. A method of ion beam generation wherein plasma is generated in a space between opposed targets (T1, T2), at least one target being composed of iron, and nitrogen gas is fed into the space to sputter said targets (T1, T2), the ionized particles (10) of iron nitride thereby generated being led outside said space in a given direction under energy control of said ionized particles (10) in an electric field (E).

2. A method according to claim 1 wherein said ionized particles (10) are emitted from said space through small through-holes (11) made in one of the targets (T2) and small through-holes (12) in a control electrode (G) set to a given potential.

3. A method according to claim 1 wherein said ionized particles (10) are led outside of said space through small through-holes made in a control electrode disposed to one side of said targets (T1, T2) in a direction perpendicular thereto and set to a given potential.

4. A method according to any one of the preceding claims wherein said ionized particles (10), after being emitted from said space, are deposited on a substrate (S) to form a thin film.

5. A method according to claim 4 wherein said ionized particles (10), after being emitted from said space, are directed to another target (T3) to sputter further ionized particles so that the former and latter ionized particles are deposited together on a substrate (S') to form a thin film.

6. A method according to any one of claims 1 to 5 wherein the ionized particles (10) are deposited to form a film at least partially composed of iron nitride as a permeable layer of a magnetic head.

7. A method according to any one of claims 1 to 5 wherein the ionized particles (10) are deposited to form a film based on amorphous iron nitride as a magnetic layer of a magnetic recording medium.

8. A method according to claim 7 wherein the ionized particles (10) are deposited together with one or more of other elements, metals, semiconductors, and non-metals to form a magnetic layer based on amorphous iron nitride.

9. An ion beam generator comprising a plurality of opposed targets (T1, T2), at least one target being composed of iron, a plasma generating means to generate plasma necessary for sputtering said targets (T1, T2) in a space between said targets (T1, T2), gas feeding means (5) to feed said space with nitrogen containing gas, at least one control electrode (G) to lead ionized particles (10) thus produced outside of the space, and means (E) to control the energy of the ionized particles (10).

10. An ion beam generator according to claim 9 additionally comprising a magnetic field generating means (3) to generate a magnetic field in said space and an acceleration electrode (13) to accelerate ionized particles produced in said space wherein said ionized particles, after being accelerated by said acceleration electrode (13), are led outside of said space through through-holes (11) made in one of the targets (T2) and then passed through through-holes (12) made in the control electrode (G) to proceed in a given direction under energy control (E).

11. An ion beam generator according to claim 9 or 10 wherein a control electrode (G) is disposed on one side of the targets (T1, T2) in a direction perpendicular thereto so that ionized particles produced in the space may be emitted across said control electrode (G) under energy control.

12. An ion beam generator according to claim 9, 10 or 11 wherein a substrate (S) is disposed outside of said control electrode (G) to deposit the ionized particles (10) thereon as they are emitted.

13. An ion beam generator according to claim 12 wherein the ionized particles (10) are directed from the control electrode (G) to another target (T3) and then to a substrate (S').

**Patentansprüche**

1. Verfahren zur Ionenstrahlerzeugung, wobei in einem Raum zwischen gegenüberliegenden Targets (T1, T2), von denen mindestens eines aus Eisen besteht, ein Plasma ausgebildet und in den Raum gasförmiger Stickstoff geleitet wird, um die Targets (T1, T2) zu zerstäuben, und wobei die dabei entstandenen ionisierten Teilchen (10) aus Eisennitrid in gegebener Richtung unter Energiesteuerung der ionisierten Teilchen (10) in einem elektrischen Feld (E) aus dem Raum herausgeführt werden.

2. Verfahren nach Anspruch 1, dadurch gekennzeichnet, daß die ioniserten Teilchen (10) aus dem Raum durch enge in einem der Targets (T2) ausgebildete durchgehende Löcher (11) und enge durchgehende Löcher (12) in einer auf ein gegebenes Potential eingestellten Steuerelektrode (G) emittiert werden.

3. Verfahren nach Anspruch 1, dadurch gekennzeichnet, daß die ionisierten Teilchen (10) durch enge in einer auf einer Seite der Targets (T1, T2) in dazu senkrechter Richtung angeordneten und auf ein gegebenes Potential eingestellten Steuerelektrode befindliche durchgehende Löcher aus dem Raum herausgeführt werden.

4. Verfahren nach einem der vorhergehenden Ansprüche, dadurch gekennzeichnet, daß die ionisierten Teilchen (10) nach ihrer Emission aus dem Raum zur Bildung eines dünnen Films auf einem Substrat (S) abgelagert werden.

5. Verfahren nach Anspruch 4, dadurch gekennzeichnet, daß die ionisierten Teilchen (10) nach ihrer Emission zur Zerstäubung weiterer ionisierter Teilchen auf ein weiteres Target (T3) gerichtet werden, so daß erstere und letztere ionisierte Teilchen zusammen zur Bildung eines dünnen Films auf einem Substrat (S') abgelagert werden.

6. Verfahren nach einem der Ansprüche 1 bis 5, dadurch gekennzeichnet, daß die ionisierten Teilchen (10) zur Bildung eines mindestens teilweise aus Eisennitrid bestehenden Films als permeable Schicht eines Magnetkopfes abgelagert werden.

7. Verfahren nach einem der Ansprüche 1 bis 5, dadurch gekennzeichnet, daß die ionisierten Teilchen (10) zur Bildung eines auf amorphem Eisennitrid basierenden Films als magnetische Schicht eines magnetischen Aufzeichnungsmaterials abgelagert werden.

8. Verfahren nach Anspruch 7, dadurch gekennzeichnet, daß die ionisierten Teilchen (10) zusammen mit einem oder mehreren weiteren Element(en), Metall(en), Halbleiter(n) und Nicht-Metall(en) zur Bildung einer magnetischen Schicht auf der Basis von amorphem Eisennitrid abgelagert werden.

9. Ionenstrahlgenerator mit mehreren gegenüberliegenden Targets (T1, T2), von denen mindestens eines aus Eisen besteht, einer Plasmaerzeugungseinrichtung zur Ausbildung eines für die Zerstäubung der Targets (T1, T2) in einem Raum zwischen den Targets (T1, T2) erforderlichen Plasmas, einer Gaszufuhreinrichtung (5) zur Beschikkung des Raums mit stickstoffhaltigem Gas, mindestens einer Steuerelektrode (G) zur Abführung der entstandenen ionisierten Teilchen (10) aus dem Raum und einer Einrichtung (E) zur Steuerung der Energie der ionisierten Teilchen (10).

10. Ionenstrahlgenerator nach Anspruch 9, der zusätzlich eine Magnetfelderzeugungseinrichtung (3) zur Ausbildung eines magnetischen Feldes in dem Raum und eine Beschleunigungselektrode (13) zur Beschleunigung der in dem Raum entstandenen ionisierten Teilchen aufweist, wobei die ionisierten Teilchen nach ihrer Beschleunigung durch die Beschleunigungselektrode (13) zur Weiterbewegung in eine gegebene Richtung unter Energiesteuerung (E) durch in einem der Targets (T2) befindliche durchgehende Löcher (11) aus dem Raum abgeführt und danach durch in der Steuerelektrode (G) befindliche durchgehende Löcher (12) hindurchgeleitet werden.

11. Ionenstrahlgenerator nach Ansprüchen 9 oder 10, dadurch gekennzeichnet, daß auf einer Seite der Targets (T1, T2) in senkrechter Richtung dazu eine Steuerelektrode (G) vorgesehen ist, so daß in dem Raum entstandene ionisierte Teilchen unter Energiesteuerung quer zur Steuerelektrode (G) emittiert werden können.

12. Ionenstrahlgenerator nach Ansprüchen 9, 10 oder 11, dadurch gekennzeichnet, daß außerhalb der Steuerelektrode (G) zur Ablagerung der ionisierten Teilchen (10) nach ihrer Emission ein Substrat (S) vorgesehen ist.

13. Ionenstrahlgenerator nach Anspruch 12, dadurch gekennzeichnet, daß die ionisierten Teilchen (10) von der Steuerelektrode (G) auf ein weiteres Target (T3) und dann auf ein Substrat (S') gerichtet werden.

**Revendications**

1. Procédé pour la production de faisceaux ioniques, dans lequel un plasma est produit dans un espace entre des cibles (T1, T2) opposées, au moins une cible étant en fer, et de l'azote gazeux est introduit dans l'espace pour pulvériser lesdites cibles (T1, T2), les particules ionisées (10) de nitrure de fer ainsi produites étant entraînées à l'extérieur dudit espace dans une direction donnée par commande de l'énergie desdites particules ionisées (10) dans un champ électrique (E).

2. Procédé selon la revendication 1, dans lequel lesdites particules ionisées (10) sont émises depuis ledit espace à travers de petits trous traversants (11) ménagés dans l'une (T2) des cibles et de petits trous traversants (12) situés dans une électrode (G) de commande réglée à un potentiel donné.

3. Procédé selon la revendication 1, dans lequel lesdites particules ionisées (10) sont entraînées à l'extérieur dudit espace à travers de petits trous traversants ménagés dans une électrode de commande disposée d'un côté desdites cibles (T1, T2) dans une direction perpendiculaire à celles-ci, et réglée à un potentiel donné.

4. Procédé selon l'une quelconque des revendications précédentes, dans lequel lesdites particules ionisées (10), après avoir été émises hors dudit espace, sont déposées sur un substrat (S) de façon à former une mince pellicule.

5. Procédé selon la revendication 4, dans lequel lesdites particules ionisées (10), après avoir été émises hors dudit espace, sont dirigées jusqu'à une autre cible (T3) afin de pulvériser encore des particules ionisées afin que les premières et les secondes particules ionisées soient déposées ensemble sur un substrat (S') de façon à former une mince pellicule.

6. Procédé selon l'une quelconque des revendications 1 à 5, dans lequel les particules ionisées (10) sont déposées pour former une pellicule au moins partiellement composée de nitrure de fer formant une couche perméable d'une tête magnétique.

7. Procédé selon l'une quelconque des revendications 1 à 5, dans lequel les particules ionisées (10) sont déposées pour former une pellicule à base de nitrure de fer amorphe formant une couche magnétique d'un support d'enregistrement magnétique.

8. Procédé selon la revendication 7, dans lequel les particules ionisées (10) sont déposées conjointement avec un ou plusieurs autres éléments, métaux, semiconducteurs et éléments non métalliques de façon à former une couche magnétique à base de nitrure de fer amorphe.

9. Générateur de faisceaux ioniques, comprenant une pluralité de cibles (T1, T2) opposées, au moins une cible étant composée de fer, un moyen de production de plasma pour produire un plasma nécessaire à la pulvérisation desdites cibles (T1, T2) dans un espace entre lesdites cibles (T1, T2), un moyen (5) d'alimentation en gaz pour introduire dans ledit espace un gaz contenant de l'azote, au moins une électrode (G) de commande pour entraîner les particules ionisées (10) ainsi produites jusqu'à l'extérieur de l'espace, et un moyen (E) pour commander l'énergie des particules ionisées (10).

10. Générateur de faisceaux ioniques selon la revendication 9, comprenant en outre un moyen (3) de création de champ magnétique pour créer un champ magnétique dans ledit espace, et une électrode (13) d'accélération pour accélérer les particules ionisées produites dans ledit espace, dans lequel lesdites particules ionisées, après avoir subi une accélération sous l'action de ladite électrode (13) d'accélération, sont entraînées à l'extérieur dudit espace à travers des trous traversants (11) ménagés dans l'une des cibles (T2), puis sont amenées à passer par des trous traversants (12) ménagés dans l'électrode (G) de commande pour se déplacer dans une direction donnée sous l'action d'une commande d'énergie (E).

11. Générateur de faisceaux ioniques selon la revendication 9 ou 10, dans lequel une électrode (G) de commande est disposée d'un côté des cibles (T1, T2), dans une direction perpendiculaire à celles-ci, de façon que les particules ionisées produites dans l'espace puissent être émises à travers ladite électrode (G) de commande par commande d'énergie.

12. Générateur de faisceaux ioniques selon la revendication 9, 10 ou 11, dans lequel un substrat (S) est disposé à l'extérieur de ladite électrode (G) de commande pour déposer les particules ionisées (10) sur celui-ci au fur et à mesure de leur émission.

13. Générateur de faisceaux ioniques selon la revendication 12, dans lequel les particules ionisées (10) sont entraînées depuis l'électrode (G) de commande jusqu'à une autre cible (T3), puis jusqu'à un substrat (S').

FIG. 1

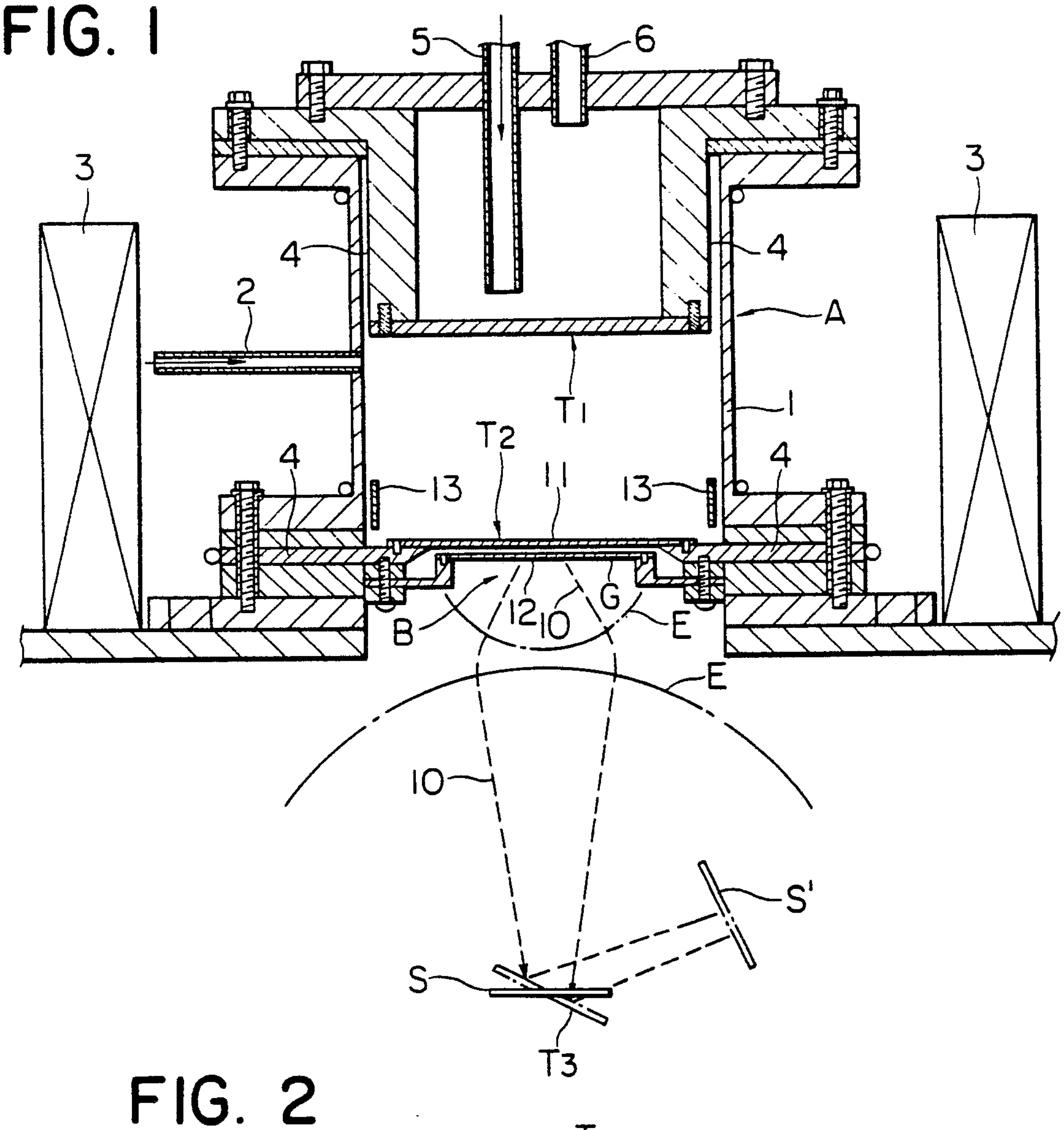
5
6
3
3
4
4
2
A
T1
1
T2
11
4
4
13
13
B
12
10
G
E
E
10
S'
S
T3

FIG. 2

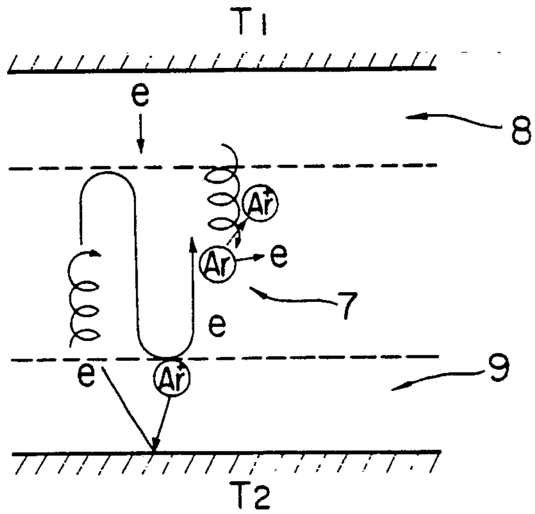
T1
e
8
Ar+
Ar
e
7
e
e
Ar+
9
T2

FIG. 3

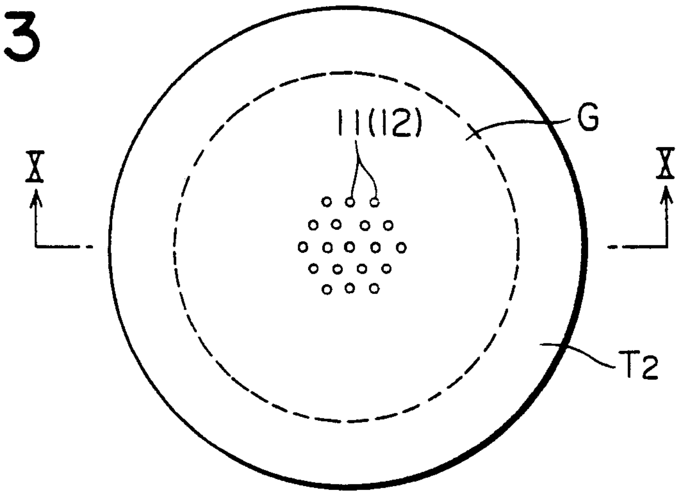


FIG. 4

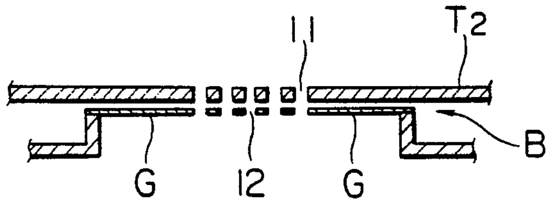


FIG. 5

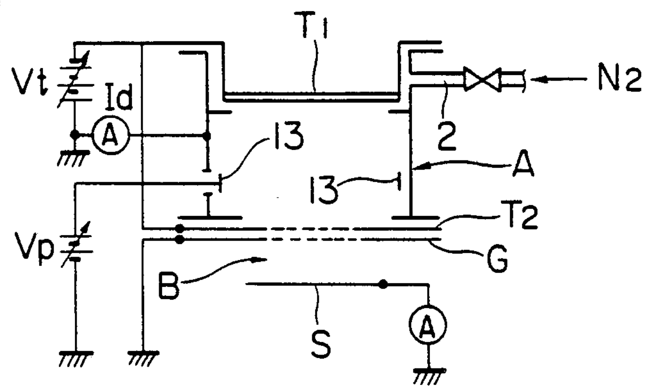


FIG. 6

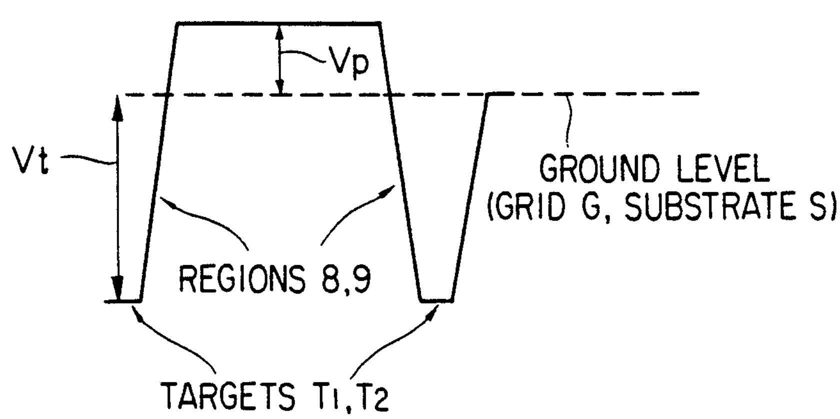

FIG. 7

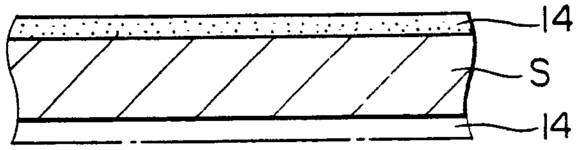


FIG. 8

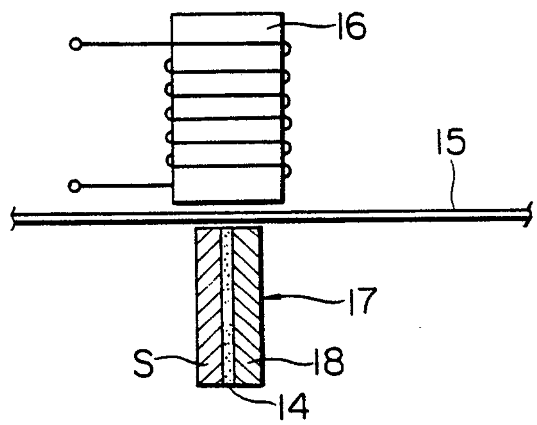


FIG. 9

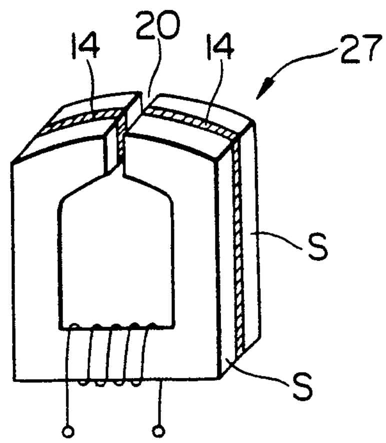

FIG. 10

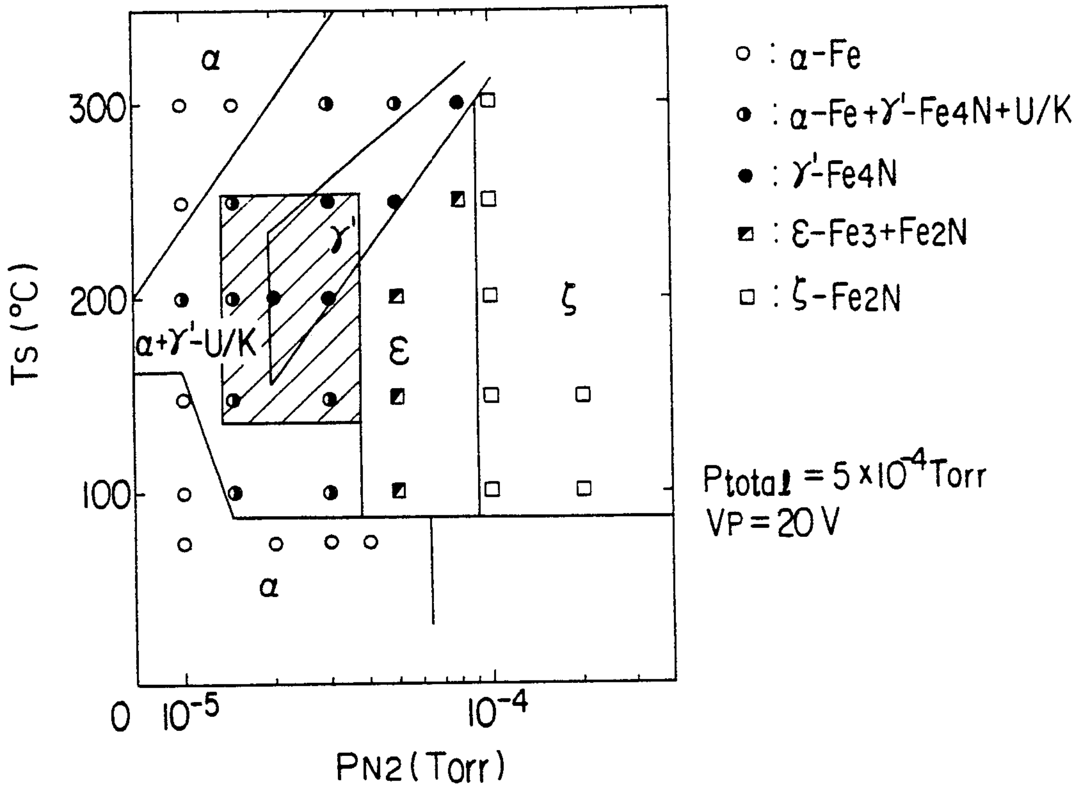
α
α+γ'-U/K
γ'
ε
ζ
α
300
200
100
Ts (°C)
0
$10^{-5}$
$10^{-4}$
PN2 (Torr)
○ : α-Fe
◑ : α-Fe+γ'-Fe4N+U/K
● : γ'-Fe4N
◩ : ε-Fe3+Fe2N
□ : ζ-Fe2N
Ptotal = 5 × $10^{-4}$ Torr
VP = 20 V

FIG. 11

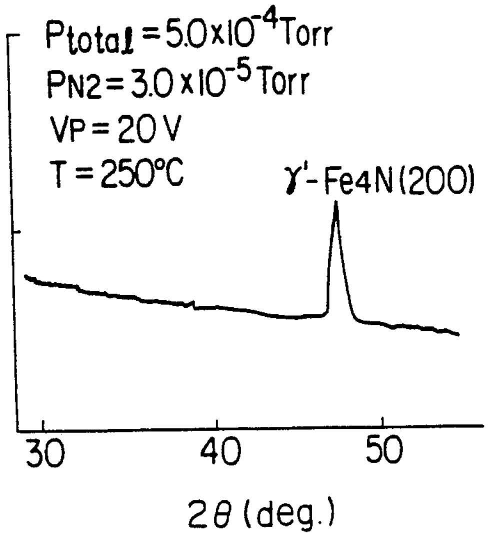
Ptotal = 5.0 × $10^{-4}$ Torr
PN2 = 3.0 × $10^{-5}$ Torr
VP = 20 V
T = 250°C
γ'-Fe4N (200)
30
40
50
2θ (deg.)

FIG. 12

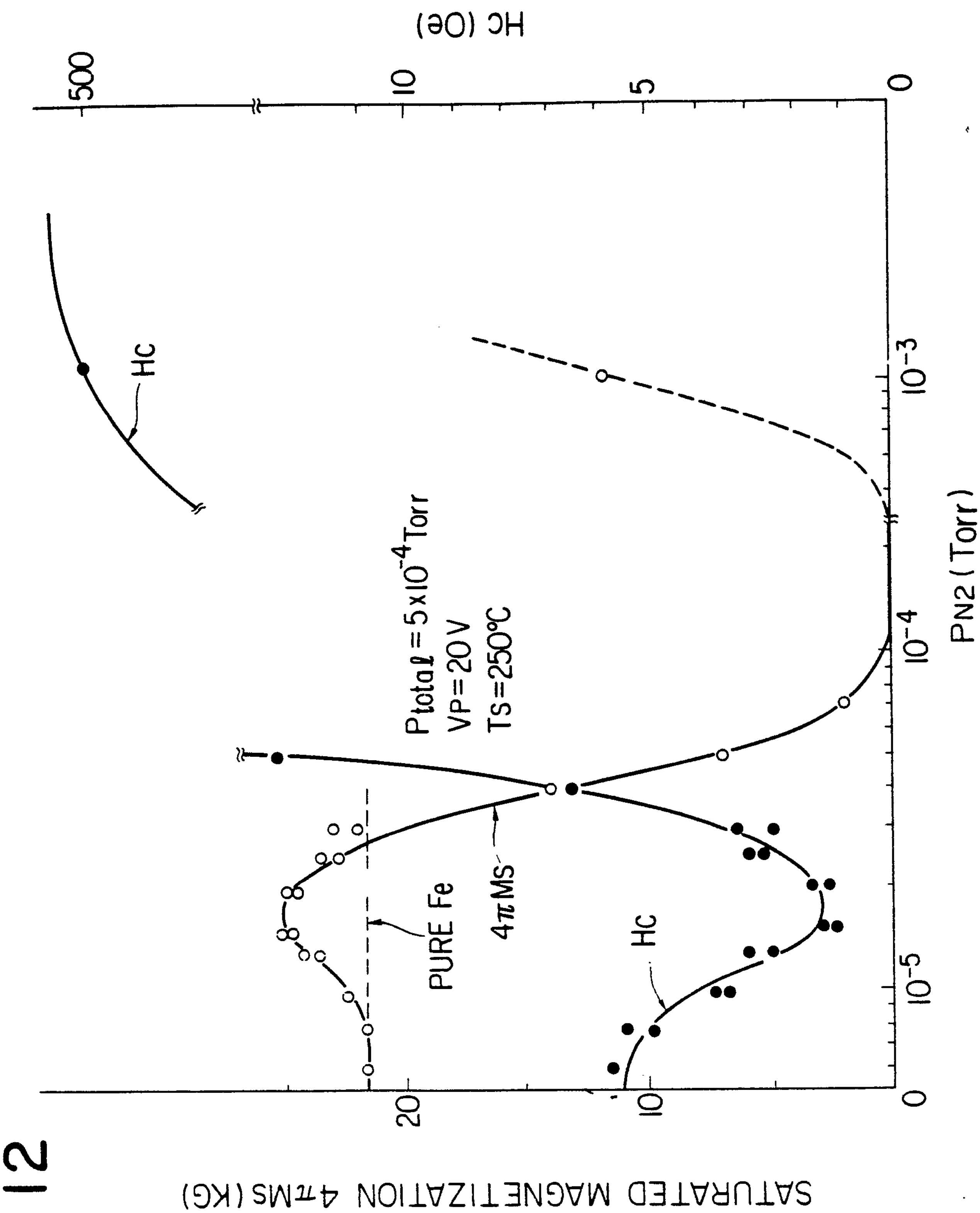
Hc (Oe)
500
10
5
0
SATURATED MAGNETIZATION 4πMs (KG)
20
10
0
PN2 (Torr)
10-5
10-4
10-3
Ptotal = 5x10-4 Torr
VP = 20 V
TS = 250°C
PURE Fe
4πMs
Hc
Hc

FIG. 13

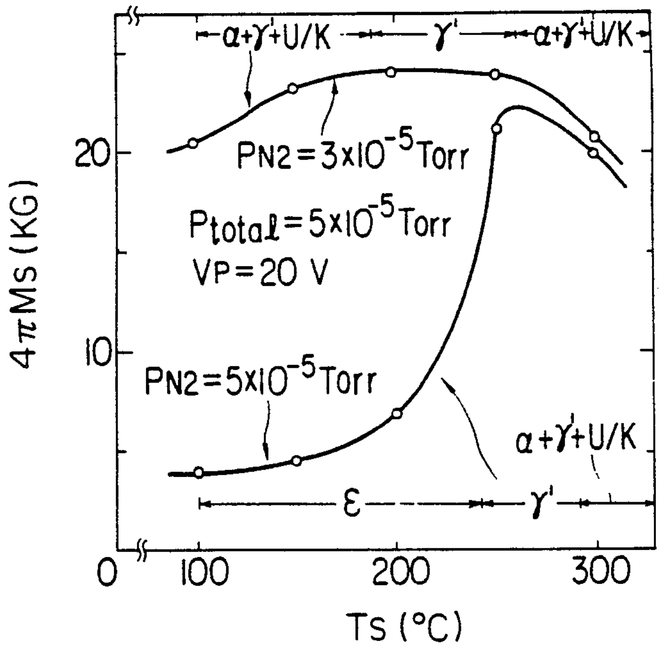
α+γ'+U/K
γ'
α+γ'+U/K
PN2=3x10^-5 Torr
Ptotal=5x10^-5 Torr
VP=20 V
PN2=5x10^-5 Torr
α+γ'+U/K
ε
γ'
4πMs (KG)
20
10
0
100
200
300
Ts (°C)

FIG. 14

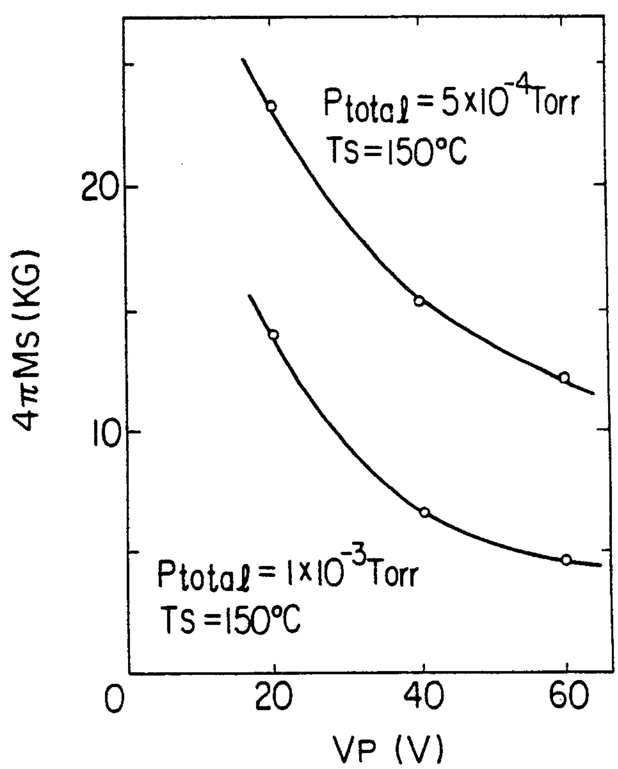
Ptotal=5x10^-4 Torr
Ts=150°C
Ptotal=1x10^-3 Torr
Ts=150°C
4πMs (KG)
20
10
0
20
40
60
VP (V)

FIG. 15